Europäisches Patentamt

European Patent Office

Office européen des brevets

(19)

(11) **EP 0 589 103 B1**

(12) # EUROPEAN PATENT SPECIFICATION

(45) Date of publication and mention
of the grant of the patent:
**01.12.1999 Bulletin 1999/48**

(51) Int Cl.⁶: **G03F 7/20**

(21) Application number: **92308599.7**

(22) Date of filing: **22.09.1992**

(54) **Image projection method and semiconductor device manufacturing method using the same**

Optische Projektionsmethode und Verfahren zur Herstellung von Halbleitervorrichtungen unter Verwendung dieser Methode

Méthode de projection d'une image et procédé de fabrication de dispositifs semi-conducteurs utilisant cette méthode

(84) Designated Contracting States:
**AT BE CH DK ES GR IE IT LI LU MC PT SE**

(43) Date of publication of application:
**30.03.1994 Bulletin 1994/13**

(73) Proprietor: **CANON KABUSHIKI KAISHA Tokyo (JP)**

(72) Inventor: **Hayata, Shigeru, c/o Canon K.K. Tokyo (JP)**

(74) Representative:
**Beresford, Keith Denis Lewis et al**
**BERESFORD & Co.**
**High Holborn**
**2-5 Warwick Court**
**London WC1R 5DJ (GB)**

(56) References cited:
**EP-A- 0 500 393**          **EP-A- 0 526 242**
**DE-A- 3 430 752**

• **PATENT ABSTRACTS OF JAPAN vol. 8, no. 286 (P-324)27 December 1984 & JP-A-59 149 317 ( NIHON KOUGAKU KOGYO KK ) 27 August 1984**
• **JAPANESE JOURNAL OF APPLIED PHYSICS vol. 30, no. 11B, November 1991, TOKYO JP pages 3021 - 3029 , XP263405 K. KAMON ET AL. 'Photolithography System Using Annular Illumination'**
• **PATENT ABSTRACTS OF JAPAN vol. 5, no. 103 (E-64)3 July 1981 & JP-A-56 045 023 ( H I T A C H I LTD ) 24 April 1981**

**Description**

This invention relates to an image projection method and a semiconductor device manufacturing method using the same. More particularly, the invention is concerned with an improved image projection method suitable for forming on a wafer a circuit pattern of a linewidth not greater than 0.5 micron and with an improved semiconductor device manufacturing method based on such an image projection method.

The degree of integration of each semiconductor device such as IC, LSI or the like has been increased more and more and, along this, the fine processing technique has been improved considerably. Particularly, the exposure technique which is the major processing technique in semiconductor device manufacturing processes has been advanced into a submicron region, with manufacture of 1 mega-DRAM. A representative exposure apparatus therefor is a reduction projection exposure apparatus, called a stepper. It is not an overestimation to say that the resolution of such a stepper determines the future of semiconductor devices.

Conventionally adopted method for improving the resolution of the stepper is mainly to enlarge the numerical aperture (NA) of a projection optical system (reduction lens system). Since however the depth of focus of a projection optical system is in inverse proportion to the square of the NA, enlarging the NA results in a decrease of the depth of focus, causing a difficulty of forming on a wafer an image of good contrast. In consideration of this problem, recently adopted method for enhancing the resolution is to use shorter wavelengths for the exposure light, such as by using i-line light (365 nm) or KrF excimer laser light (248 nm) in place of g-line light (436 nm). This relies upon an effect that, if the depth of focus allowable in the optical system is considered as constant, the resolution increase in inverse proportion to the root of the wavelength.

On the other hand, independently of enlarging the NA of a projection optical system or using shorter wavelengths of exposure light, there is a method of improving the resolution of a stepper by illuminating a reticle in a specific manner. An example according to this method is that a reticle is illuminated with the light which forms a ring-like effective light source (a virtual light source formed by zeroth order light) at a pupil of a projection optical system. With this method, diffraction light (zeroth and first orders) produced by a circuit pattern of a reticle can be projected onto the pupil of the projection optical system. The light that forms a ring-like effective light source can be supplied by forming a ring-like secondary light source at a position within the illumination system which is optically conjugate with the pupil of the projection optical system. Such an arrangement is disclosed in an article by Kamon et al (Japanese Journal of Applied Physics Vol. 20 No. 11B, Nov 91, Tokyo, Japan, Pages 3021-3029 entitled 'Photolithography System Using Annular Illumination'.

With this illumination method, however the depth of focus of the projection optical system is not so improved and, therefore, if this illumination method is applied to a projection exposure apparatus, it is not easy to obtain an image of good contrast.

In accordance with one aspect, the present invention provides an image projection method comprising the steps of

illuminating a fine pattern including longitudinal and transverse patterns; and
projecting diffraction light caused by the fine pattern onto a pupil of a projection optical system,

characterised in that
the fine pattern is illuminated with such light that defines on the pupil an effective light source of substantially rectangular ring-like shape having sides extending in the directions of the longitudinal and transverse patterns.

In accordance with another aspect, the present invention provides an image projection apparatus comprising

an illumination device for illuminating a fine pattern including longitudinal and transverse patterns; and
a projection optical system for projecting diffracted light from the fine pattern onto a pupil;

characterised in that the illumination device is arranged to form a substantially rectangular ring-like shaped illumination source having sides extending in the directions of the longitudinal and transverse patterns in use.

Thus the fine pattern is illuminated with such light that on the pupil there is defined an effective light source of substantially rectangular shape having sides extending in the directions of the longitudinal and transverse patterns, constituting the circuit pattern, by which the depth of focus of the projection optical system can be improved.

The "side" of the effective light source means the side that defines the basic configuration of the effective light source. It comprehends not only the one provided by connected straight lines as viewed microscopically but also the one which is provided by connected curved lines as viewed microscopically but the connections of which are along a predetermined straight line when viewed macroscopically.

In a preferred form of the present invention, the inside peripheral configuration of the ring-like effective light source is mainly defined by those sides extending in the aforementioned directions, and the sides of the inside peripheral configuration includes a first pair of sides which are symmetrical with respect to an axis parallel to the direction of elongation of a transverse pattern, extending through the center of the pupil, and a second pair of sides which are symmetrical with respect to an axis parallel to the direction of elongation of a longitudinal pattern, extending through the center of the pupil. Also, the peripheral configuration of the ring-like effective light source is mainly defined by those sides extending in the aforementioned directions, and the sides of the peripheral configuration includes a third pair of sides which are symmetrical with respect to an axis parallel to a transverse pattern, extending through the center of the pupil, and a fourth pair of sides which are symmetrical with respect to an axis parallel to a longitudinal pattern, extending through the center of the pupil.

Thus, it is possible to select illumination with the light which defines an effective light source having inside and peripheral configurations providing a substantially rectangular shape.

Since in the present invention the illumination uses the light which defines an effective light source such as described, it is possible to improve the depth of focus of a projection optical system, in respect to longitudinal and transverse patterns, as compared with the illumination using the light which defines a circular effective light source of conventional type.

The light that defines an effective light source as described can be supplied by providing a primary or secondary light source of a shape analogous to that of the effective light source, at a position optically conjugate with the pupil of the projection optical system.

Embodiments of the present invention will now be described with reference to the accompanying drawings, in which:

Figure 1 is a schematic view of a projection exposure apparatus to which a method of the present invention is applied.

Figure 2 is a schematic view of an effective light source on a pupil in the apparatus of Figure 1.

Figure 3 is a schematic view of an aperture stop in an illumination optical system of the Figure 1 apparatus.

Figures 4A - 4C are schematic views for explaining the advantages of the effective light source applied to the Figure 1 apparatus, wherein Figure 4A illustrates longitudinal and transverse patterns, Figure 4B illustrates preferable distribution of diffraction light upon the pupil, and Figure 4C illustrates the basic form of the effective light source that produces the diffraction light distribution of Figure 4B.

Figure 5 is a graph showing the relationship between the linewidth of a bar chart image and the depth of focus of a projection lens system, based on the results of computer simulation made on the imaging characteristic in accordance with an image projection method, for forming a rectangular ring-like effective light source of Figure 4C, and an image projection method for forming a circular effective light source.

Figure 6 is a schematic view of variations of the effective light source of the present invention.

Figure 7 is a sectional view of an optical integrator of the Figure 1 apparatus.

Figure 8 is a schematic view of an effective light source on the pupil of the Figure 1 apparatus, as can be seen practically.

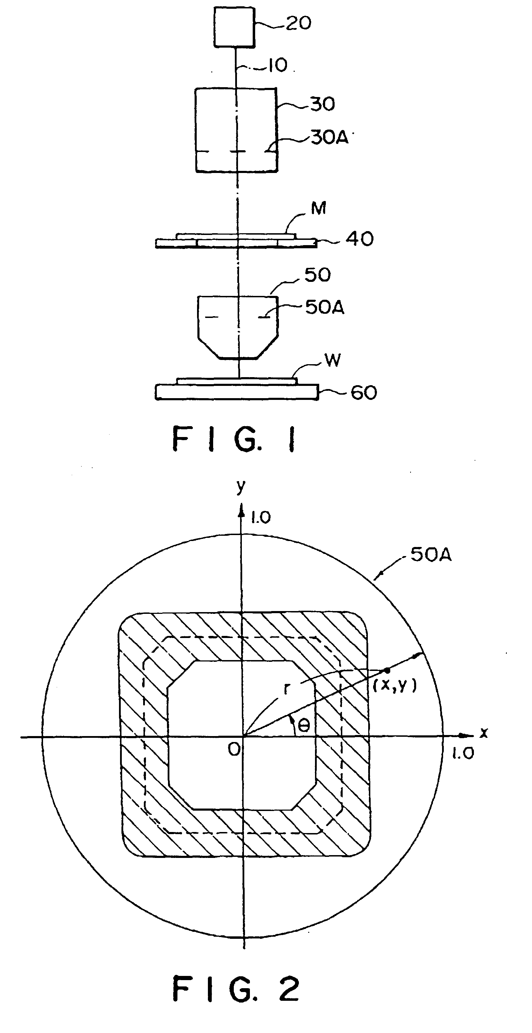

Figure 1 shows a projection exposure apparatus for manufacturing semiconductor devices in accordance with a method of the present invention.

Denoted in Figure 1 at M is a reticle having a circuit pattern formed thereon. Denoted at W is a wafer which is coated with a resist. Denoted at 10 is an optical axis of the apparatus; at 20 is a light source (primary light source); at 30 is an illumination optical system for directing light from the light source 20 to the reticle M; and at 30A is an aperture stop of the illumination optical system 30. The aperture stop 30A is placed in the neighbourhood of the light exit surface of an optical integrator (fly's eye lens), not shown, of the illumination optical system 30, and it cooperates with the optical integrator to form a ring-like secondary light source at its opening. Denoted at 40 is a reticle stage for supporting the reticle M; at 50 is a projection lens system for projecting a reduced image of the circuit pattern of the reticle M uniformly illuminated with the light from the ring-like secondary light source of the illumination optical system 30; and denoted at 50A is an aperture stop of the projection lens system 50. The aperture stop 50A defines the pupil of the projection lens system 50. Here, the position of the stop 50 is taken as the position of the pupil. Denoted at 60 is a wafer stage for supporting the wafer W, and this stage 60 supports the wafer W so as to bring the wafer W surface into alignment with the imaging plane of the circuit pattern of the reticle M by the projection lens system 50.

When in the above-described structure the reticle M is illuminated by using the light source 20 and the illumination optical system 30, diffraction light caused by the circuit pattern of the reticle M, mainly consisting of a combination of longitudinal and transverse patterns), is received by the opening of the stop 50A of the projection lens system 50. Thus, with the diffraction light, the projection lens system 50 projects an image of the circuit pattern of the reticle M onto the wafer W, whereby the image of the circuit pattern is transferred to the resist of the wafer W. Through such exposure-transfer process, semiconductor chips can be manufactured from the wafer W.

In the apparatus of Figure 1, the position of the stop 30A of the illumination optical system 30 and the position of the stop 50A of the projection lens system 50 are placed in an optically conjugate relationship with each other, and an image of the opening of the stop 30A (i.e. secondary light source) is projected upon the opening of the stop 50A of the projection lens system 50. Thus, by appropriately setting the shape and/or the size of the opening of the stop 30A (i.e. the shape or size of the secondary light source), the shape or size of the image of the opening of the stop 30A to be formed on the opening of the stop 50A (namely, the shape or size of the effective light source) is determined appropriately. It is to be noted that the opening of the stop 50A has a circular shape.

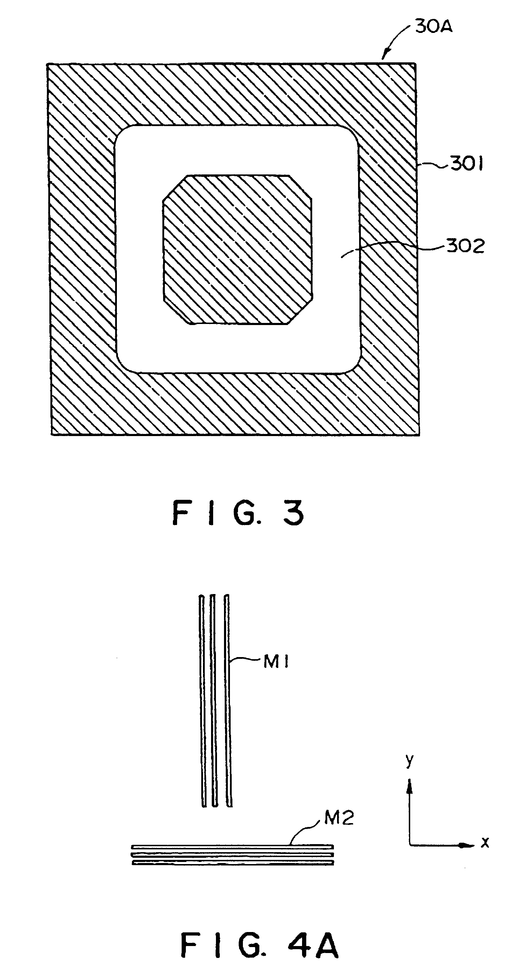

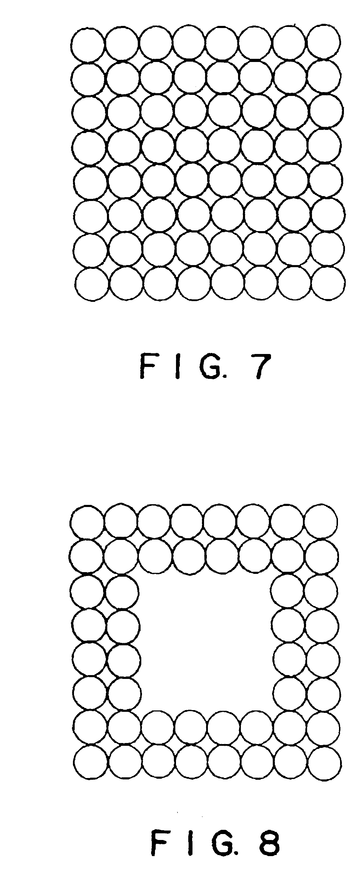

Figure 2 is a schematic view of the effective light source defined on the pupil (hereinafter "pupil 50A") of the projection lens system 50 of Figure 1, and Figure 3 is a front view of the stop 30A of the illumination optical system 30 of the Figure 1 apparatus. In Figure 2, the pupil 50A of the projection lens system 50 as well as the effective light source are illustrated with reference to an x-y coordinate system with its origin coinciding with the center of the pupil 50A. The x axis of this x-y coordinate system corresponds to the direction of elongation of a transverse pattern (linear pattern extending transversely or laterally) of the reticle M, while the y axis of the x-y coordinate system corresponds to the direction of elongation of a longitudinal pattern (linear pattern extending longitudinally) of the reticle M. Since the optical integrator of the Figure 1 apparatus comprises a fly's eye lens consisting of a combination of lens elements as illustrated in the sectional view of Figure 7, the effective light source as can be practically observed upon the pupil 50A is such as shown in Figure 8. This effective light source is figured by curved lines defined by connected peripheral configurations of images of the inside and outside lens elements, but here the peripheral configuration of the effective light source is taken as one figured by lines extending along the array of the images of the inside and outside lens elements.

As depicted by a hatched zone in Figure 2, in the Figure 1 apparatus a ring-like effective light source having sides extending along the directions of elongation of the longitudinal and transverse patterns of the reticle M, is formed on the pupil 50A. This effective light source comprises a ring-like effective light source whose inside and outside peripheral configurations are approximately rectangular.

When polar coordinates $(r, \theta)$ are defined in Figure 2 $(x = r\cos\theta, y = r\sin\theta)$ and if the center of the pupil 50A is denoted by $r = 0$ and the radius of the pupil 50A is denoted by $r = 1$, then $Rm(\theta)$ of the gravity center position $(Rm(\theta), (\theta))$ of the intensity $I(r, \theta)$ of each of the portions of the effective light source extending radially with an angle $\theta$ from the x axis of the pupil 50A, can be expressed as follow:

$$Rm(\theta) = \{\int_0^1 r \cdot I(r, \theta)dr\}/\{\int_0^1 I(r,\theta)dr\}$$

The broken line shown in Figure 2 depicts a line connecting the gravity center positions $(Rm(\theta), \theta)$ with respect to $0 = 0$ to 360 (deg). And, the feature of this effective light source is that: the effective light source of this embodiment takes an approximately rectangular shape wherein most of the lines connecting the gravity center positions in respect to the radial direction (r direction) in the range of $\theta = 0$ to 360 (deg), are parallel to the x or y axis; and that the effective light source is symmetrical with respect to the x and y axes. Also, this effective light source is so set that zeroth order diffraction light and first order diffraction light caused by longitudinal and/or transverse patterns (of the circuit pattern of the reticle M and having a minimum linewidth) are incident and distributed on the pupil 50A at those positions which are symmetrical with respect to the x or y axis. The intensities of the portions of the effective light source are substantially at the same level, and the effective light source as a whole has a substantially flat light intensity;

As shown in Figure 3, the stop 30A of the Figure 1 apparatus comprises a stop member having a ring-like opening 302 defined by a light blocking portion 301, the opening 302 having inside and outside peripheral configurations of approximately rectangular shape, for defining the effective light source of Figure 2 upon the pupil 50A. Thus, in the illumination optical system 30, a ring-like effective light source having inside and outside peripheral configurations of approximately rectangular shape, is defined. While no x-y coordinate system is illustrated in Figure 3, from the comparison with Figure 2 it will be clear that the origin coincides with the center (optical axis) of the opening 30, that the transverse direction in the drawing corresponds to the x axis extending through the origin and that the longitudinal direction in the drawing corresponds to the y axis extending through the origin.

In the apparatus of Figure 1, the reticle M is so illuminated that an image of the opening of the stop 30A shown in Figure 3 is projected on the pupil 50A of the projection lens system 50, by which an approximately rectangular ring-like effective light source is formed on the pupil, while on the other hand an image of the circuit pattern of the reticle M is projected on the wafer W. Thus, as compared with the projection method wherein a circular effective light source is projected on a pupil of a projection lens system, it is possible to enlarge the depth of focus of the projection lens system with respect to the imaging of longitudinal and transverse patterns of the circuit pattern of the reticle M. Consequently, the image of the fine longitudinal and transverse patterns of the circuit pattern of the reticle M can be projected on the wafer W, stably and at high contrast. The reason for this will be explained in more detail, below.

Through investigations made by the applicants, it has been found that, in a case where fine longitudinal and transverse patterns are illuminated obliquely with light from a position off the axis, such as the light from a ring-like secondary light source, for imaging the patterns with diffraction light caused by the patterns, degradation of image quality (e.g. distortion of image) due to the defocusing is minimized when, on the pupil of a projection optical system, zeroth order diffraction light and first order diffraction light are distributed at those positions symmetrical with respect to x or y axis of an x-y coordinate system (see Figure 2) of the pupil. This is because in this occasion the difference in wavefront aberration between the zeroth order diffraction light and the first order diffraction light becomes smallest. This means that, if the zeroth order light and the first order light are distributed symmetrically with respect to the x or y axis, to a pattern of small linewidth causing a problem of the depth of focus, then the depth of focus in respect to the imaging of a pattern of fine linewidth can be improved.

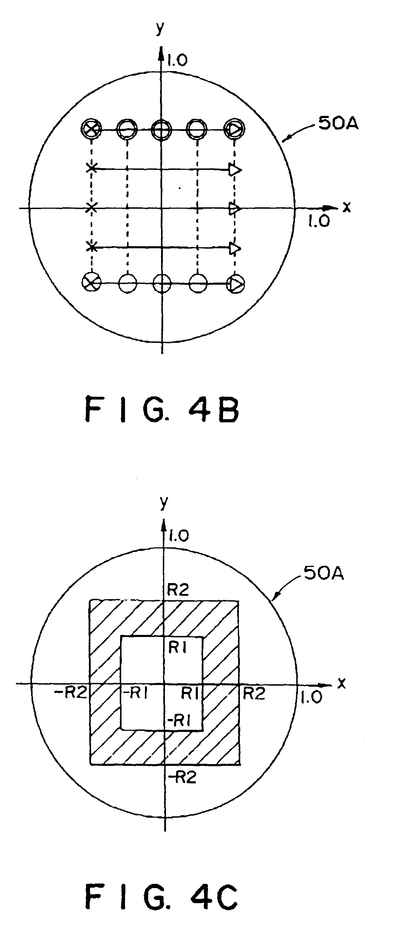

In summary, when longitudinal patterns M1 and transverse patterns M2 such as shown in Figure 4A are to be imaged, as an example, distribution of diffraction light such as shown in Figure 4B is preferable. In Figure 4B, the symbols ,⊚ △, ○ and X denote zeroth order diffraction light and first order diffraction light. More specifically, the symbols ⊚ and ○ denote the pair of diffraction lights produced by the pattern M1, wherein, if the symbol ⊚ depicts the zeroth order light, the symbol ○ depicts the first order light, whereas if the symbol ○ depicts the zeroth order light, the symbol ⊚ depicts the first order light. On the other hand, the the symbols △ and X denote the pair of diffraction lights produced by the pattern M2, wherein, if the symbol △ depicts the zeroth order light, the symbol X depicts the first order light, whereas if the symbol X depicts the zeroth order light, the symbol △ depicts the first order light. These diffraction lights are distributed on the pupil 50A so as to define rectangular peripheral configurations. Such distribution of diffraction light may be accomplished by forming on the pupil 50A a ring-like effective light source such as shown in Figure 4C, having inside and outside peripheral configurations of square shape and having its center coinciding with the center (optical axis) of the pupil. If to the contrary a circular ring-like effective light source is formed on the pupil, there are produced pairs of diffraction lights which are not symmetrical with respect to the x or y axis of the x-y coordinate system of the pupil. These diffraction lights result in degradation of image quality due to defocusing, in the imaging of fine longitudinal and transverse patterns.

In consideration of the inconveniences such as above, in the present invention in order that the diffraction lights are so distributed as to form a rectangular peripheral configuration about the center of the pupil or a configuration like it, an effective light source having inside and outside peripheral configurations of square shape or rectangular shape or, alternatively, of a deformed shape of it, is provided.

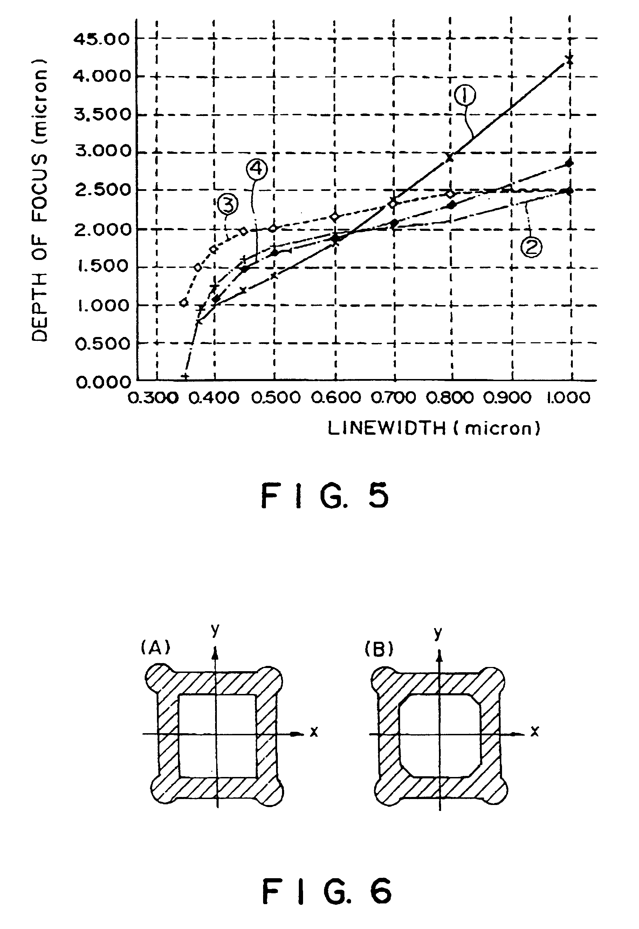

Figure 5 shows the comparison results of computer simulation made on the imaging characteristic, according to the image projection method wherein a rectangular ring-like effective light source of Figure 4C is formed and according to the image projection method wherein a circular ring-like effective light source is formed. During the simulation, a projection lens of a numerical aperture (NA) of 0.52 and a bar chart of one dimensional line-and-space, having five lines, were selected, and the relationship between the linewidth of the bar char image and the depth of focus at a contrast 7% was examined under the condition that the bar chart image was imaged by using i-line (wavelength 365 nm). In Figure 5, curve (1) depicts the characteristic of longitudinal and transverse patterns when an effective light source of Gaussian intensity distribution, having a highest intensity at the pupil center, is formed. Curve (2) depicts the characteristic of longitudinal and transverse patterns when a circular ring-like effective light source is formed. Curve (3) depicts the characteristic of longitudinal and transverse patterns when a rectangular ring-like effective light source is formed. Curve (4) depicts the characteristic of inclined (45 deg.) patterns when a rectangular ring-like effective light source is formed. In the case of curve (2), the size of the circular ring-like effective light source is such that, if the radius of the pupil is taken as 1, the radius of the inside circular peripheral configuration is 0.4 while the radius of the outside peripheral configuration is 0.8. In the cases of curves (3) and (4), the size of the rectangular ring-like effective light source is such that, in Figure 4C (the radius of the pupil is 1), R1 = 0.4 and R2 = 0.64.

As seen from Figure 5, the imaging characteristic of the inclined 45 deg. patterns when a rectangular ring-like effective light source is formed and the imaging characteristic of the longitudinal and transverse patterns when a circular ring-like effective light source is formed, are substantially the same. The imaging characteristic of the longitudinal and transverse patterns when a rectangular ring-like effective light source is formed is superior to that of the longitudinal and transverse patterns where an effective light source of Gaussian intensity distribution is formed or to that of the longitudinal and transverse patterns where a circular effective light source is formed; and the depth of focus to the longitudinal and transverse patterns is improved considerably. If the allowable depth of focus in a semiconductor device manufacturing exposure apparatus (stepper) such as shown in Figure 1 is 1.5 micron, the limit resolution to longitudinal and transverse patterns in a case where a circular effective light source is formed is 0.44 micron, whereas the limit resolution to longitudinal and transverse patterns in a case where a rectangular ring-like effective light source is formed is 0.37 micron. Thus, use of the image projection method in which a rectangular ring-like effective light source is formed, assures enhancement of limit resolution to longitudinal and transverse patterns. Since a circuit pattern is mainly composed of longitudinal and transverse patterns, the enhancement of limit resolution or depth of focus in relation to such longitudinal and transverse patterns provides a large advantageous effect.

According to the investigations made by the applicants, preferable forms of such a rectangular ring-like effective light source are those such as shown in Figure 4C, or those having a similar shape wherein, when standardization is made while taking the radius of the pupil as 1, the inside and outside peripheral configurations of the effective light source are in the ranges of $0.1 \leq R1 \leq 0.65$ and $0.25 \leq R2 \leq 0.71$.

In the apparatus of Figure 1, the stop 30A shown in Figure 3 is used to provide a secondary light source having inside and outside peripheral configurations of square-like shape, and an effective light source of a shape analogous to such secondary light source is defined on the pupil 50A. However, it is within the scope of the present invention to provide a secondary light source or an effective light source of a shape other than this, for projection of an image. Examples are illustrated in Figure 6A and 6B wherein the hatching depicts an effective light source. In the effective light sources shown in Figures 6A and 6B, at least one of the inside and outside peripheral configurations includes a side which extends in the direction of elongation of a longitudinal or transverse pattern. Also, in these effective light sources, the lines connecting the gravity centers with respect to the radial direction (such as shown by a broken line in Figure 2) take an approximately rectangular shape and, in respect to the imaging of longitudinal and transverse patterns, it is possible to obtain a depth of focus greater than that attainable with a circular effective light source. In order to obtain effective light sources such as shown in Figures 6A and 6B, the stop 30A of the illumination optical system of the Figure 1 apparatus may be replaced by a stop member having an opening of a shape like the hatched portion in Figure 6A or 6B.

While in the stop 30A of Figure 3 the portion other than the opening 302, namely, the light blocking portion 301 is arranged to fully block light, the stop may be modified so that light is partially transmitted through this portion. What is important is that the intensity of light passing through the opening 302 is sufficiently higher than that passing through the remaining portion, and that, when an image of the opening 302 is formed on the pupil 50A, an effective light source with inside and outside peripheral configurations at least one of which includes a side extending in the direction of elongation of a longitudinal or transverse pattern, is defined on the pupil 50A.

Also, it is preferable that the secondary light source or the effective light source has a uniform intensity distribution.

In the apparatus of Figure 1, a fly's eye lens having lens elements of circular cross-section such as shown in Figure 7 is used. However, a fly's eye lens comprising a combination of lens elements having a square cross-section or a hexagonal cross-section, may be used.

Also, in the apparatus of Figure 1, the stop 30A is disposed adjacent to the light exit surface of the optical integrator, it may be placed in the neighbourhood of the light entrance surface of the optical integrator. In that occasion, a rectangular ring-like secondary light source is defined on the light entrance surface of the optical integrator, and an image of such secondary light source is projected on the pupil 50A of the projection lens system 50. Further, in the apparatus of Figure 1, a lens element or elements which are at the central portion of the optical integrator do not contribute to the definition of the ring-like secondary light source and, therefore, such an optical integrator not having such lens element or elements is possible to use. Alternatively, the light receiving surface of such central lens element or elements of the optical integrator may be covered by a light blocking film or the like. Moreover, the structure of the illumination optical system may be modified in various ways, known in the art. Further, as the light source 20, an ultra-high pressure Hg lamp or an excimer laser may be used, for example.

In the apparatus of Figure 1, a projection lens system is used to project an image of the pattern of the reticle M. However, the invention is applicable also to an apparatus using a projection mirror system for the projection of an image of a pattern. Further, the invention is not limited to the projection of an image of a circuit pattern. It is applicable also to a different lithography technique, for example, for producing a device by using projection of an image of a fine grating pattern.

In the present invention as described hereinbefore, for projection of an image of a fine pattern having longitudinal and transverse patterns, an effective light source of an approximately rectangular shape having sides extending along the directions of elongation of the longitudinal and transverse patterns is formed on a pupil of a projection optical system. This assures enlargement of the depth of focus of the projection optical system. Thus, when the method of the present invention is applied to an exposure apparatus, it is possible to improve the limit resolution significantly.

## Claims

1. An image projection method comprising the steps of

   illuminating a fine pattern (M) including longitudinal and transverse patterns; and
   projecting diffraction light caused by the fine pattern (M) onto a pupil (50A) of a projection optical system (50),

   characterised in that
   the fine pattern (M) is illuminated with such light that defines on the pupil (50A) an effective light source of substantially rectangular ring-like shape having sides extending in the directions of the longitudinal and transverse patterns.

2. An image projection method as claimed in claim 1, wherein a stop (30A) having a rectangular ring-like opening is disposed in an illumination optical system (30) and, through the function of this stop (30A), said rectangular ring-like effective light source is defined on the pupil of the projection optical system (50).

3. An image projection method as claimed in claim 1 or 2, wherein zeroth order and first order diffraction light caused by said pattern (M) is incident and distributed on the pupil (50A) so as to define thereon a rectangular configuration about the center of the pupil (50A), and the longitudinal and transverse patterns are imaged with the diffraction light.

4. An image projection method as claimed in claim 1 or 2, wherein the sides of the inside peripheral configuration of the effective light source comprises a first pair of sides which are symmetrical with each other with respect to an axis extending through the center of the pupil (50A) and in parallel to the transverse pattern, and a second pair of sides which are symmetrical with each other with respect to an axis extending through the center of the pupil and in parallel to the longitudinal pattern; wherein the outside peripheral configuration of the effective light source is mainly composed of sides extending in said directions, respectively; and wherein the sides of the outside peripheral configuration comprises a third pair of sides which are symmetrical with each other with respect to an axis extending through the center of the pupil (50A) and in parallel to the transverse pattern, and a fourth pair of sides which are symmetrical with each other with respect to an axis extending through the center of the pupil and in parallel to the longitudinal pattern.

5. An image projection method as claimed in claim 4, wherein when the radius of the pupil (50A) is 1, the distance of the first and second pairs of sides from the optical axis is R1, and the distance of the third and fourth pairs of sides from the optical axis is R2, the following relations are satisfied:

$$0.1 \leq R1 \leq 0.65$$

$$0.25 \leq R2 \leq 0.71.$$

6. A method of manufacturing a device comprising the image projection method as claimed in any one of claims 1 to 5 for exposing a workpiece to the fine pattern (M), and the step of fabricating a device using the exposed workpiece.

7. An image projection apparatus comprising

an illumination device (30) for illuminating a fine pattern (M) including longitudinal and transverse patterns; and a projection optical system (50) for projecting diffracted light from the fine pattern (M) onto a pupil (50A);

characterised in that the illumination device (30) is arranged to form a substantially rectangular ring-like shaped illumination source having sides extending in the directions of the longitudinal and transverse patterns in use.

8. An image projection apparatus as claimed in claim 7 wherein said illumination device (30) comprises an optical integrator.

9. An image projection apparatus as claimed in claim 7 or claim 8 wherein said illumination device (30) includes an optical stop (30A) having a substantially rectangular ring-like opening for forming the substantially ring like shaped illumination source.

10. An image projection apparatus as claimed in claim 9 wherein said optical stop (30A) is arranged symmetrically about an axis of said illumination device (30).

11. An image projection apparatus as claimed in claim 10 wherein said optical stop (30A) and said projection optical system (50) arranged to form a substantially rectangular ring-like shaped source at the pupil (50A) having inner sides a distance R1 from said axis and outer sides a distance R2 from said axis, where

$$0.1 \leq R1 \leq 0.65$$

$$0.25 \leq R2 \leq 0.71.$$

**Patentansprüche**

1. Optische Projektionsmethode bzw. Bildprojektionsmethode, welche die Schritte aufweist:

   - Beleuchten einer Feinstruktur (M) mit Längs- und Querstrukturen, und
   - Projizieren von Beugungslicht, das durch die Feinstruktur (M) verursacht ist, auf eine Pupille (50A) eines optischen Projektionssystems (50),

   **dadurch gekennzeichnet, daß**
   die Feinstruktur (M) mit solchem Licht beleuchtet wird, das auf der Pupille (50A) eine wirksame Lichtquelle von im wesentlichen Rechteck-Ringform definiert, die Seiten aufweist, die sich in die Richtungen der Längs- und der Querstruktur erstrecken.

2. Bildprojektionsmethode gemäß Anspruch 1, wobei eine Blende (30A) mit einer rechteckig-ringförmigen Öffnung in einem optischen Beleuchtungssystem (30) angeordnet ist und durch die Funktion dieser Blende (30A) die rechteckigringförmige wirksame Lichtquelle auf der Pupille des optischen Projektionssystems (50) definiert wird.

3. Bildprojektionsmethode gemäß Anspruch 1 oder 2, wobei Beugungslicht nullter Ordnung und erster Ordnung, das durch die Struktur (M) verursacht ist, auf die Pupille (50A) einfällt und verteilt wird, um darauf eine rechteckige Ausbildung um den Mittelpunkt der Pupille (50A) zu definieren, und Längs- und Querstrukturen mit dem Beugungslicht abgebildet werden.

4. Bildprojektionsmethode gemäß Anspruch 1 oder 2, wobei die Seiten der inneren Randausbildung der wirksamen Lichtquelle ein erstes Paar von Seiten aufweisen, welche in bezug auf eine Achse, die sich durch den Mittelpunkt der Pupille (50A) erstreckt, einander symmetrisch und parallel zu der Querstruktur sind, und ein zweites Paar von Seiten, welche in bezug auf eine Achse, die sich durch den Mittelpunkt der Pupille erstreckt, einander symmetrisch und parallel zu der Längsstruktur sind, wobei die äußere Randausbildung der wirksamen Lichtquelle hauptsächlich aus Seiten zusammengesetzt ist, die sich in die jeweiligen Richtungen erstrecken, und wobei die Seiten der äußeren Randausbildung ein drittes Paar von Seiten aufweisen, welche in bezug auf eine Achse, die sich durch den Mittelpunkt der Pupille (50A) erstreckt, einander symmetrisch und parallel zu der Querstruktur sind, und ein viertes Paar von Seiten, welche in bezug auf eine Achse, die sich durch den Mittelpunkt der Pupille erstreckt, einander symmetrisch und parallel zu der Längsstruktur sind.

5. Bildprojektionsmethode gemäß Anspruch 4, wobei in dem Fall, wenn der Radius der Pupille (50A) 1 beträgt, der Abstand des ersten und des zweiten Paars von Seiten von der optischen Achse R1 ist und der Abstand des dritten und des vierten Paars von Seiten von der optischen Achse R2 ist, wobei die folgenden Beziehungen erfüllt sind:

$$0,1 \leq R1 \leq 0,65$$

$$0,25 \leq R2 \leq 0,71.$$

6. Verfahren zur Herstellung einer Vorrichtung, welches die Bildprojektionsmethode gemäß einem der Ansprüche 1 bis 5 zum Belichten eines Arbeitsgegenstands mit der Feinstruktur (M) und den Schritt des Herstellens einer Vorrichtung unter Verwendung des belichteten Arbeitsgegenstands aufweist.

7. Bildprojektionsvorrichtung, die aufweist:

   - eine Beleuchtungseinrichtung (30) zum Beleuchten einer Feinstruktur (M) mit Längs- und Querstrukturen und
   - ein optisches Projektionssystem (50) zum Projizieren des von der Feinstruktur (M) gebeugten Lichts auf eine Pupille (50A),

**dadurch gekennzeichnet, daß** die Beleuchtungseinrichtung (30) angeordnet ist, um eine im wesentlichen rechteckigringförmige Beleuchtungsquelle mit Seiten auszubilden, die sich beim Verwenden in die Richtungen der Längs- und Querstruktur erstrecken.

8. Bildprojektionsvorrichtung gemäß Anspruch 7, wobei die Beleuchtungseinrichtung (30) eine optische Integrationseinrichtung aufweist.

9. Bildprojektionsvorrichtung gemäß Anspruch 7 oder Anspruch 8, wobei die Beleuchtungseinrichtung (30) eine optische Blende (30A) mit einer im wesentlichen rechteckig-ringförmigen Öffnung zum Ausbilden der im wesentlichen ringförmigen Beleuchtungsquelle aufweist.

10. Bildprojektionsvorrichtung gemäß Anspruch 9, wobei die optische Blende (30A) um eine Achse der Beleuchtungseinrichtung (30) symmetrisch angeordnet ist.

11. Bildprojektionsvorrichtung gemäß Anspruch 10, wobei die optische Blende (30A) und das optische Projektionssystem (50) angeordnet sind, um eine im wesentlichen rechteckigringförmige Quelle auf der Pupille (50A) auszubilden, mit inneren Seiten in einem Abstand R1 von der Achse und äußeren Seiten in einem Abstand R2 von der Achse, wobei gilt:

$$0{,}1 \leq R1 \leq 0{,}65$$

$$0{,}25 \leq R2 \leq 0{,}71.$$

**Revendications**

1. Procédé de projection d'image comprenant les étapes dans lesquelles

   on illumine un motif fin (M) comprenant des motifs longitudinaux et transversaux ; et
   on projette une lumière de diffraction provoquée par le motif fin (M) sur une pupille (50A) d'un système optique de projection (50),

   caractérisé en ce que
   le motif fin (M) est illuminé avec une lumière telle qu'elle définit sur la pupille (50A) une source de lumière efficace ayant une forme analogue à un anneau sensiblement rectangulaire ayant des côtés s'étendant dans des directions des motifs longitudinaux et transversaux.

2. Procédé de projection d'image selon la revendication 1, dans lequel un diaphragme (30A) ayant une ouverture analogue à un anneau rectangulaire est disposé dans un système optique d'illumination (30) et, de par la fonction de ce diaphragme (30A), ladite source de lumière efficace analogue à un anneau rectangulaire est définie sur la pupille du système optique de projection (50).

3. Procédé de projection d'image selon la revendication 1 ou 2, dans lequel de la lumière de diffraction d'ordre zéro et de premier ordre provoquée par ledit motif (M) tombe et est distribuée sur la pupille 50A afin de définir sur elle une configuration rectangulaire autour du centre de la pupille (50A), et des images des motifs longtudinaux et transversaux sont formées par la lumière de diffraction.

4. Procédé de projection d'image selon la revendication 1 ou 2, dans lequel les côtés de la configuration périphérique intérieure de la source de lumière efficace comprennent une première paire de côtés qui sont symétriques entre eux par rapport à un axe passant par le centre de la pupille (50A) et parallèle au motif transversal, une seconde paire de côtés qui sont symétriques entre eux par rapport à un axe passant par le centre de la pupille et parallèle au motif longitudinal ; dans lequel la configuration périphérique extérieure de la source de lumière efficace est principalement composée de côtés s'étendant dans lesdites directions, respectivement ; dans lequel les côtés de la configuration périphérique extérieure comprennent une troisième paire de côtés qui sont symétriques entre eux par rapport à un axe passant par le centre de la pupille (50A) et parallèle au motif transversal, et une quatrième paire de côtés qui sont symétriques entre eux par rapport à un axe passant par le centre de la pupille et parallèle au motif longitudinal.

**5.** Procédé de projection d'image selon la revendication 4, dans lequel, lorsque le rayon de la pupille (50A) est égal à 1, la distance des première et seconde paires de côtés à partir de l'axe optique est R1, et la distance des troisième et quatrième paires de côtés à partir de l'axe optique est R2, les relations suivantes sont satisfaites :

$$0,1 \leq R1 \leq 0,65$$

$$0,25 \leq R2 \leq 0,71.$$

**6.** Procédé de fabrication d'un dispositif comprenant le procédé de production d'image selon l'une quelconque des revendications 1 à 5 pour exposer une pièce au motif fin (M), et l'étape de fabrication d'un dispositif en utilisant la pièce exposée.

**7.** Appareil de projection d'image comportant

un dispositif d'illumination (30) destiné à illuminer un motif fin (M) comprenant des motifs longitudinal et transversal ; et
un système optique de projection (50) destiné à projeter de la lumière diffractée depuis le motif fin (M) sur une pupille (50A) ;

caractérisé en ce que le dispositif d'illumination (30) est agencé de façon à former une source d'illumination d'une forme analogue à un anneau sensiblement rectangulaire ayant des côtés s'étendant dans les directions des motifs longitudinal et transversal lors de l'utilisation.

**8.** Appareil de projection d'image selon la revendication 7, dans lequel ledit dispositif d'illumination (30) comporte un intégrateur optique.

**9.** Appareil de projection d'image selon la revendication 7 ou la revendication 8, dans lequel ledit dispositif d'illumination (30) comprend un diaphragme optique (30A) ayant une ouverture analogue à un anneau sensiblement rectangulaire pour former la source d'illumination d'une forme sensiblement analogue à un anneau.

**10.** Appareil de projection d'image selon la revendication 9, dans lequel ledit diaphragme optique (30A) est agencé symétriquement par rapport à un axe dudit dispositif d'illumination (30).

**11.** Appareil de projection d'image selon la revendication 10, dans lequel ledit diaphragme optique (30A) et ledit système optique de projection (50) sont agencés pour former une source d'une forme analogue à un anneau sensiblement rectangulaire à la pupille (50A) ayant des côtés intérieurs à une distance R1 dudit axe et des côtés extérieurs à une distance R2 dudit axe, où

$$0,1 \leq R1 \leq 0,65$$

$$0,25 \leq R2 \leq 0,71.$$

F I G. 1

F I G. 2

30A

301

302

## F I G. 3

M1

M2

y

x

## F I G. 4A

F I G. 4B

F I G. 4C

F I G. 5

F I G. 6

14

F I G. 7

F I G. 8